# EUROPEAN PATENT APPLICATION

(11) **EP 4 741 837 A1**
(43) Date of publication of application: **13.05.2026**
(21) Application number: 24212210.9
(22) Date of filing: 11.11.2024
(51) Int. Cl.: G01R 15/16, G01R 15/18

(54) **ARRANGEMENT FOR DETECTING AT LEAST ONE ELECTRIC PARAMETER, ELECTRIC MEASUREMENT SYSTEM AND METHOD FOR MANUFACTURING AN ELECTRIC MEASUREMENT SYSTEM**

(71) Applicant: Janitza electronics GmbH, 35633 Lahnau (DE)
(72) Inventor: ANDREEßEN, Marec, 35644 Hohenahr (DE); WOLF, Christian, 35781 Weilburg (DE)
(74) Representative: Fuchs Patentanwälte Partnerschaft mbB

(57) **Abstract**

The disclosure concerns an arrangement (10) for detecting at least one electric parameter, an electric measurement (40) system and method for manufacturing an electric measurement system (40). The arrangement (10) is configured to detect at least one electric parameter and comprises:
• a carrier element (12) having a plurality of through holes (14) for passing a respective first electrical conductor (11) through each through hole (14) along a respective first axis (A);
• a plurality of detection units (16) each being aligned with one of the through holes (14), wherein each detection unit (16) comprises at least one second electrical conductor (20) which extends at least partially in a circumferential direction around the first axis (A);
• one or more measurement units (24) each being configured to measure at least one electric parameter of one or more of the second electrical conductors (20), the electric parameter varying according to an electrical field generated by one of the first electrical conductors (11).

## Description

The present disclosure relates to an arrangement for detecting at least one electric parameter, an electric measurement system and a method for manufacturing an electric measurement system.

### Background

In known electrical systems, power from a utility source can be distributed to branch circuits via a panelboard, with circuit breakers installed for protection against overloads. In such systems, an overload occurs when the load exceeds the circuit's capacity. Current transformers are often used to measure current in each branch circuit by stepping down the primary current to safer, standardized values. Current transformers work through a conductive core and wire windings, and the step-down ratio depends on the windings. Traditional current transformers only measure current when it's actively flowing.

For these reasons, WO 2021 / 243 304 A1 discloses a system that attempts to sense both current and electric fields in a power circuit, using a current transformer for current measurement and an antenna to detect the electric field, thereby allowing detection even without active current. The antenna can be arranged in a housing together with the current transformer and/or can be fixed to a same base as the housing and current transformer.

### Details of invention

The present disclosure seeks to enable an accurate detection of electric parameters with an improved structure.

This object is solved by the independent claims. Optional embodiments are set out in this description, in the figures and in the dependent claims.

Accordingly, an arrangement for detecting at least one electric parameter, e.g. at least one type of electric parameter for and/or by each of a number of detection units, is disclosed, the arrangement comprising:
- a carrier element having a plurality of through holes for passing a respective first electrical conductor through each through hole along a respective first axis;
- a plurality of detection units each being aligned with one of the through holes, wherein each detection unit comprises at least one second electrical conductor which extends at least partially in a circumferential direction around the first axis;
- one or more measurement units each being configured to measure at least one electric parameter of one or more of the second electrical conductors, the electric parameter varying according to an electrical field generated by one of the first electrical conductors, and in particular by the first electrical conductor that is respectively associated with the through hole with which the detection unit comprising said second electrical conductor is aligned. In other words, the first electrical conductor generating the electrical field may be the respective one of the first electrical conductors that passes through the through hole having the first axis around which the second electrical conductor extends at least partially in circumferential direction.

This arrangement may enable an accurate detection of the electric parameter at a low structural complexity. For example, the arrangement may be easily retrofittable to expand or add measurement capabilities of existing devices.

The first electrical conductor(s) are not an integral part of the disclosed arrangement but may, for instance, be inserted into the through holes during real-world use of the arrangement. Alternatively, the first electrical conductor(s) may form an integral part of the disclosed arrangement, e.g. being pre-installed within the through holes for direct use in real-world applications.

Through each through hole, an individual first electric conductor may pass along a first axis associated with said through hole. Each first axis may extend orthogonally to a respectively associated through hole and in particular to an opening cross-section of said through hole. Each first axis may be a linear axis and/or may extend orthogonally to the carrier element. All first axes may extend in parallel to each other.

Terms such as "axial", "radial" and "circumferential" may relate to a first axis. A radial direction may define an extension along a first axis, a radial direction may define an extension at an angle and in particular orthogonally to a first axis, a circumferential direction may define an extension about a first axis.

All through-holes and/or all second electrical conductors may be configured similarly, e.g. in terms of shape and dimension. All through-holes and/or all second electrical conductors may be aligned along a common axis, such as the below discussed second axis, wherein the common axis is in particular a linear axis. The through-holes and/or second electrical conductors may be equidistantly spaced from a respectively adjacent through-hole and/or second electrical conductor, in particular when viewed along the above-mentioned common axis.

The carrier element may be plate-shaped. It may be configured as a basis and/or a platform for supporting any of the components arranged thereat. It may be a single-layer component or a multi-layer component. It may comprise electrically conductive materials, such as conductive traces, and/or electrically nonconductive materials, such as a plate material.

Each detection unit may generally be configured to capture the electrical field and/or generate an electrical measurement signal in response thereto. On the other hand, the detection unit may not be configured to perform signal processing of the electrical measurement signal on its own and/or may generally be passive in terms of signal processing. For example, it may be free of any processing units, such as a CPU, or digital communication interfaces. Its function may include and may in particular be limited to detecting and optionally relaying the electric measurement signal, in particular without interpreting or analyzing it. For example, the electrical measurement signal may be transmitted to the measurement unit, e.g. by a wire or conductive trace, for further processing and analysis.

The electric parameter may be an electric voltage or electric current. An electric measurement signal generated by a detection unit that is output to a measurement unit, e.g. via a PCB conductive trace or wire, may be an analogue electric signal. It may be amplified, filtered, buffered or otherwise conditioned e.g. in the detection unit or in the measurement unit. This may help to reduce noise and/or increase signal strength. Such a conditioning may prepare for an actual processing and in particular an actual analysis of the conditioned electric measurement signal by the measurement unit, e.g. so as to quantify the electric parameter and/or generate other data, in particular digital data, based on said conditioned signal.

The measurement unit may be configured to process analogue signals, such as the electrical measurement signal captured by the detection unit. The measurement unit may be configured to process said electrical measurement signal in particular in terms of determining the electrical parameter based thereon. The measurement unit may include components such as a CPU or similar circuitry, which perform the signal processing and/or signal analysis of the signal received from the detection unit. The measurement unit may comprise a be connected to a digital or analogue communication interface for forwarding data, e.g. digital or analogue data, on the determined electrical parameter.

There may e.g. be one measurement unit measuring and/or receiving signals from each or at least from several of the detection units. There may e.g. be one measurement unit per detection unit, e.g. measuring and/or receiving signals from only a distinct one of the detection units. There may be mixed forms of the preceding embodiments with at least one measurement unit measuring and/or receiving signals from several of the detection units and at least one measurement unit measuring and/or receiving signals from only a distinct one of the detection units.

The alignment of any of the detection units with a through hole may e.g. include any degree of overlap between the detection unit and the through hole. This may in particular concern an overlap between a cross-section of the detection unit and/or through hole with a respective cross-sectional plane extending orthogonally to the first axis. Additionally or alternatively, the alignment of any of the detection units with a through hole may e.g. include the detection unit at least partially enclosing the through hole. The overlap and/or enclosing may e.g. be present in an orthogonal projection of the detection unit and through hole along the first axis into a common plane, in particular into a virtual plane and/or a surface plane of the carrier element. Additionally or alternatively, the alignment of any of the detection units with a through hole may include, but is not limited to, a concentric arrangement and/or a congruent arrangement of the detection unit and through hole.

According to an embodiment, the second electrical conductor is or comprises a conductive foil, in particular a copper foil. The foil may e.g. be curved and/or may define at least a section of a cylindrical surface (in other words, a lateral surface of a cylinder). The second electrical conductor may have a hollow cylindrical and/or bushing-like shape. It may extend concentrically with respect to and/or about the first axis.

The one or more measurement units and/or detection units may be supported by the carrier element. For example, they may be soldered or otherwise attached thereto. Additionally or alternatively, the measurement unit(s) and/or detection units may be connected to power lines and/or signal lines and/or conductive traces comprised by the carrier element. According to an embodiment, the carrier element is a printed circuit board, in particular comprising conductive traces.

Accordingly, each detection unit and/or the one or more measurement units may be surface mounted to the carrier element and/or may be soldered to the carrier element.

According to an embodiment, the second electrical conductor of at least one of the detection units extends with a closed circumference around the first axis, in particular wherein the second electrical conductor has a hollow cylindrical shape. For example, the second electrical conductor may have a tube-shape, a ring-shape, sleeve-shape or a bushing-shape. A cross-section of the second electrical conductor and/or its closed circumferential shape may be circular. Additionally or alternatively, said cross-section and/or said closed circumferential shape may correspond to a cross-sectional shape and/or circumferential shape of a respectively associated through-hole.

According to an embodiment, at least one of the detection units has a support member extending at least partially in a circumferential direction around the first axis, wherein the second electrical conductor is supported by and in particular attached to the support member. The support member may support and e.g. stabilize the second electrical conductor. A cross-sectional shape and/or a circumferential shape of the support member may correspond to that of the second electrical conductor and/or of a respectively associated through-hole. Said cross-sectional shape and/or circumferential shape may in particular be circular. In one example, the support member has a hollow cylindrical shape and/or a bushing-like shape.

According to an embodiment, the support member is electrically non-conductive. For example, it may comprise a plastic material or be a plastic part.

According to an embodiment, the support member has a first face, e.g. an inwardly facing face or a radially inner face, facing the second electrical conductor and in particular extending circumferentially around the second electrical conductor. The support member may also have a second face facing away from the first face, wherein the second electrical conductor is arranged at the second face. The second face may be an outwardly facing face or a radially outer face, such as an outer lateral face of the support member.

According to an embodiment, the detection unit and/or the through holes are aligned along a second axis, in particular wherein the second axis extends at an angle to at least one first axis and in particular to each first axis (e.g. each first axis of each through hole).

According to an embodiment, the arrangement further comprises at least one shielding structure that is arranged in between at least two of the detection units and that is configured to at least partially electromagnetically shield said detection units from one another. The shielding structure may be or may comprise a plate, it particular an electrically conductive plate. The shielding structure may extend orthogonally to the carrier element or at another angle to the carrier element. The shielding structure may have a depth dimension extending along a first axis and a length dimension extending along the carrier element. The shielding structure may optionally not extend circumferential about any adjacent first axis, but may e.g. be a straight and/or planar member. The length dimension can be at least half as long as a respective length dimension of the respectively adjacent detection units. The depth dimension can be at least half as long as a respective depth dimension of the respectively adjacent detection units.

According to an embodiment, the arrangement comprises a plurality of shielding structures that are comprised by a common shielding member arranged at and/or fastened to the carrier member. For example, the shielding member may be a metallic member in or at which a number of respective shielding structures are formed. For example, the shielding member may have a grid-like structure with at least one cell of the grid at least partially enclosing one of the through holes and/or detection units. Said cell may comprise at least one shielding structure. Additionally or alternatively, the shielding member may have at least one elongated section, such as a web or arm, that extends along the through holes and/or the second axis. From said elongated section, the shielding structures may extend so as to be arranged in between respectively adjacent through-holes and/or detection units.

According to a further embodiment, at least some of the detection units may comprise a shielding structure that is axially adjacent to, in particular directly adjacent to, the second conductor of the detection unit. For example, the shielding structure may be similarly shaped and/or dimensioned as the second conductor. In one example, the shielding structure is a ring or a bushing. The shielding structure may e.g. be axially aligned with or arranged in an axial succession with the second conductor. The shielding structure may be electrically connected to a ground potential.

There may be at least two shielding structures per detection unit, in particular in form of electrically conductive rings. The second conductor of a detection unit that is used for capturing an electrical measurement signal in response to a generated electric field - and that is e.g. connected to a respective measurement signal line or conductive trace - may be arranged axially in between the at least two shielding structures. Alternatively, there may be only one shielding structure per detection unit, in particular in form of an electrically conductive ring. This shielding structure may optionally have a different axial dimension compared to the second conductor capturing the electric measurement signal. In particular, this shielding structure may be axially longer than said second conductor.

Accordingly, in one embodiment at least one of the detection units has one second electrical conductor that is electrically connected to the one or more measurement units, e.g. so as to capture the electric field and generate an electric measurement signal in response thereto that is to be processed by the measurement units. Further, the at least one of the detection unit has at least one further second electrical conductor that is electrically connected to a ground potential. This further second electrical conductor may resemble a shielding structure as discussed above, in particular in from of a shielding ring. The further second electrical conductor may not be electrically connected to any measurements units.

The invention also relates to an electric measurement system, comprising a first arrangement that is an arrangement according to any of the previous aspects; and a second arrangement, the second arrangement comprising a plurality of second detection units, e.g. each comprising at least one current transformer, and each configured to sense an electrical current present in one of the respective first electrical conductors; wherein each second detection unit comprises a receiving section for passing a respective first electrical conductor through, each receiving section being aligned with one of the through holes and/or detection units of the first arrangement.

The first electrical conductor(s) are not an integral part of the disclosed system but may, for instance, be inserted into said system during real-world use of the arrangement. Alternatively, the first electrical conductor(s) may form an integral part of the disclosed system, e.g. being pre-installed for direct use in real-world applications.

Providing separate first and second arrangements having individual carrier elements and components may help to increase the degrees of freedom of design. For example, each arrangement can be individually optimized for an automated component placement on their respective carrier elements. Also, the carrier elements can be arranged in a space efficient manner relative to one another.

Specifically, according to one embodiment, the second arrangement comprises a further carrier element at which the second detection units are arranged, wherein the further carrier element extends orthogonally or at another angle (i.e. an angle that is different from 0°, but not 90°) to the carrier element of first arrangement.

According to a further embodiment, the first arrangement and the second arrangement are configured for wire-bound signal transmission between each other. For example, each of the first and second arrangement may comprise at least one hardware interface, wherein said interfaces are connectable to one another for a signal transmission.

According to a further embodiment, the first arrangement and the second arrangement are at least partially received in a common housing. The housing may be a single part or a multi-part housing. It may enclose the first and second arrangement so as to protect them from environmental influences. The housing may comprise openings e.g. for making optional external communication interfaces accessible. Additionally or alternative, the housing may comprise openings for inserting the disclosed first electrical conductors, e.g. so as to extend through the housing while passing through the through holes and/or first and second detection units of the first and second arrangement, respectively.

The invention also relates to an arrangement for detecting electric parameters of an electrical conductor, the arrangement comprising:
- a carrier element having a plurality of through holes for passing a respective first electrical conductor through each through hole along a respective first axis;
- a plurality of first detection units, each first detection unit being assigned to and aligned with one of the through holes such that an assigned one of the first electrical conductors can pass through the respective first detection unit and each being configured to sense an electrical voltage present in the assigned one of the first electrical conductors, e.g. each first detection unit is a capacitive voltage detection unit; and
- a plurality of second detection units, each second detection unit being assigned to and aligned with one of the through holes such that an assigned one of the first electrical conductors can pass through the respective second detection unit and each being configured to sense an electrical current present in the assigned one of the first electrical conductors, e.g. each comprising at least one current transformer,
wherein the carrier element is arranged between the plurality of first detection units and the plurality of second detection units.

Each second detection unit can comprise a receiving section for passing the assigned first electrical conductor through. Each receiving section is spaced from and aligned with the assigned one of the first detection units.

Each first detection unit can comprise at least one second electrical conductor which extends at least partially in a circumferential direction around the respective first detection unit's center axis.

The arrangement can comprise one or more measurement units each being configured to measure at least one electric parameter of one or more first detection unit and/or second detection unit.

The invention also relates to an arrangement for detecting electric parameters of an electrical conductor, the arrangement comprising:
- a plurality of first detection units being arranged on a first carrier element, each first detection unit being assigned to and aligned with a first electrical conductor such that the assigned first electrical conductor can pass through the respective first detection unit and each first detection unit being configured to sense an electrical voltage present in the assigned first electrical conductor, e.g. each first detection unit is a capacitive voltage detection unit; and
- a plurality of second detection units being arranged on a second carrier element, each second detection unit being assigned to and aligned with a first electrical conductor such that the assigned first electrical conductor can pass through the respective second detection unit and each second detection unit being configured to sense an electrical current present in the assigned first electrical conductor, e.g. each comprising at least one current transformer,
wherein a first central axis of each first detection unit and a second central axis of each respective second detection unit are aligned, while the first carrier and the second carrier are arranged at an angle to each other, the angle being between 40° and 140°, or between 60° and 120°, or between 80° and 100°, or 90°.

The invention also relates to an arrangement for detecting at least one electric parameter, e.g. at least one type of electric parameter for and/or by each of a number of detection units, the arrangement comprising:
- a carrier element having a plurality of through holes for passing a respective first electrical conductor through each through hole along a respective first axis;
- a plurality of detection units each being aligned with one of the through holes, wherein each detection unit comprises at least one second electrical conductor which extends at least partially in a circumferential direction around the first axis and each configured to detect an electrical voltage present in one of the respective first electrical conductors;
- a plurality of second detection units each configured to detect an electrical current present in one of the respective first electrical conductors;
wherein each second detection unit comprises a receiving section for passing a respective first electrical conductor through, each receiving section being aligned with one of the through holes and/or one of the first detection units.

The arrangement can comprise one or more measurement units each being configured to measure at least one electric parameter first detection units and/or the second detection units, the electric parameter varying according to an electrical field generated by one of the first electrical conductors, and in particular by the first electrical conductor that is respectively associated with the through hole with which the first and second detection units assigned thereto are aligned. In other words, the first electrical conductor generating the electrical field may be the respective one of the first electrical conductors that passes through the through hole and through the assigned first detection unit and the assigned second detection unit.

The invention also relates to a method for manufacturing an electric measurement system, the electric measurement system comprising a first arrangement that is an arrangement according to any the aspects disclosed herein; and a second arrangement, the second arrangement comprising a plurality of second detection units each configured to sense an electrical current present in one of the respective first electrical conductors;
wherein each second detection unit comprises a receiving section for passing a respective first electrical conductor through, each receiving section being aligned with one of the through holes and/or detection units of the first arrangement, and wherein the second arrangement comprises a further carrier element at which the second detection units are arranged; wherein the method comprises: arranging the carrier element of the first arrangement and at angle to the further carrier element of second arrangement.

Features, effects, embodiments, optional configurations and explanations described with regard to one aspect of the invention can also apply to the other aspects.

### Brief Description of the Drawings

Exemplary embodiments of the invention are discussed below with respect to the attached schematic Figures. Same features may be marked with same reference signs throughout the Figures. In the Figures, only selected instances of a feature may be marked with a respective reference sign, although further instances of said feature may be depicted.
- Figure 1: illustrates an embodiment of an arrangement for detecting at least one electric parameter according to an embodiment of this disclosure, this arrangement resembling a first arrangement of an electric measurement system according to an embodiment of this disclosure;
- Figure 2: illustrates an embodiment of a second arrangement of an electric measurement system according to an embodiment of this disclosure;
- Figure 3: shows an embodiment of an electric measurement system according to an embodiment of this disclosure and comprising the first and second arrangements of Figures 1 & 2, respectively.
- Figure 4: is a first view of an exemplary housing of the electric measurement system according to Figure 3.
- Figure 5: is a second view of the housing of Figure 4.

### Detailed Description of the Disclosure

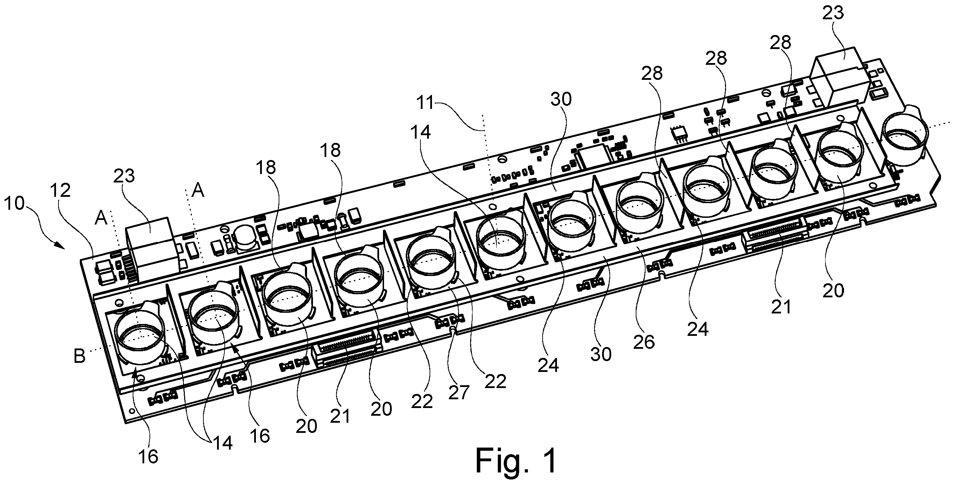

Figure 1 illustrates an embodiment of an arrangement 10 for detecting at least one electric parameter of and/or by each of a number of detection units 16. The arrangement 10 comprises a carrier element 12 in form of a printed circuit board, PCB. In the shown example, the carrier element 12 is a one-piece PCB or, in other words, a continuous planar element. The carrier element 12 has a number of partially optional components that are attached thereto according to any known technology. Only selected ones of these components are discussed here below. Any non-described, yet depicted component may be omitted.

In the carrier element 12, a number of through holes 14 is formed, only some of which are marked with a respective reference sign. In the depicted example, the through holes 14 are identically sized and shaped. Accordingly, they define identically sized circular openings. Further, they are aligned along an axis B that is also referred to as a second axis herein. In a non-limiting manner, the through holes 14 are equidistantly spaced form one another along said axis B. This helps to improve compactness and to simplify manufacture, e.g. when automatically mounting the below discussed detection units 16 at each one of the through-holes 14.

For selected ones of the through holes 14, an axis A is marked that extends orthogonally to an opening cross-section of said through holes 14 and orthogonally to a plane of the carrier element 12. In the depicted example, each axis A extends through a geometric center of the respectively associated through hole 14. Any axis A is also referred to as a first axis herein. Such a first axis A can be defined for each of the through holes 14, although not respectively depicted. Each axis A extends orthogonally to the axis B.

In Fig. 1, a first side of the carrier element 12 faces the viewer. Along said first side and each aligned with one of the through holes 14, a number of detection units 16 is arranged. Each detection unit 16 comprises a tube-and/or bushing-like support member 18 that is made of a nonconductive material, such as a plastic material. Each support member 18, only selected ones of which are marked with a respective reference sign, extends axially along the first axis A and circumferentially about the first axis A of a respectively associated through hole 14. Each support member 18 has a relatively thin wall thickness of e.g. not more than 5 mm or not more than 2 mm. The support members 18 of the shown arrangement 10 are generally identical. Again, this configuration helps to reduce complexity and to simplify manufacture.

In a non-limiting exemplary manner, at least an inner cross-section or opening of each support member 18 is similarly sized and/or dimensioned to a respectively associated through-hole 14, e.g. has the same circular shape and/or diameter. Further, each support member 18 is e.g. arranged concentrically with each through-hole 14. This way, a first electrical conductor 11 can be easily inserted through each one of the through holes 14 without structural obstructions. For one of the through holes 14, an exemplary first electrical conductor 11 that is e.g. in form of a wire is schematically indicated. As an exemplary feature, the depicted arrangement 18 comprises twelve through-holes 14. Accordingly, twelve first electrical conductors 11 may be inserted into the arrangement 10, one through each through hole 14. Each first electrical conductor 11 may comprise a single conductor, e.g. a single wire, or a plurality of wires, e.g. resembling a stranded conductor.

The detection units 16 further each comprise a second electrical conductor 20 which is arranged at a radially outer circumferential face of each support member 18. Each second electrical conductor 20 comprises or consists of a metallic foil, such as a copper foil. Each second electrical conductor 20 has a bushing- or tube-like shape, thus resembling a hollow cylinder. Each second electrical conductor 20 has a closed circular cross-section matching the dimensions of the radially outer lateral surface of each support member 18. Combining the support members 18 and second electrical conductors 20 enables a reduced material usage when configuring the second electrical conductors 20, in particular a reduced wall thickness thereof. This helps to reduce costs.

Generally, each support member 18 may be a rigid and/or stiff part, whereas each second electrical conductor 20 may be less stiff and/or less rigid. Further, a wall thickness of each support member 18, in particular a radial wall thickness, may be larger than that of each second electrical conductor 20, e.g. at least twice as large. This way, the second electrical conductor 20 can be supported and e.g. stiffened by each support member 18 in a particularly reliable manner.

As indicated for one example in Figure 1, the detection units 16 are surface mounted to the carrier element 12 by solder joints 22. There may be more or less solder joints 22 than visible in Figure 1, e.g. at least one further solder joint 22 at a side of each detection unit 16 facing away from the viewer. Surface mounting the detection units 16 to the carrier element 12 simplifies manufacture and in particular simplifies an automation of the manufacturing process.

As schematically indicated for one of the detection units 16, there is also at least one conductive trace 27 that electrically connects at least one of the solder joints 22 (or at least the second electrical conductor 20) to a measurement unit 24. Part of the conductive trace 27 is obstructed by a shielding member 26 discussed below. In a non-limiting manner, the exemplary embodiment of Figure 1 includes one measurement unit 24 for each detection unit 16.

By way of the conductive trace 27, an electric signal that is picked up and/or generated by the second electrical conductor 20 of each respective detection unit 16 is transmitted to a respectively connected measurement unit 24, e.g. as an analogue electric measurement signal. The measurement unit 24 includes at least one CPU to analyze and/or measure this signal and to quantify at least one electric parameter based thereon. Optionally, the measurement unit 24 includes or is connected to non-specifically illustrated components for conditioning the electric measurement signal prior to said signal being analyzed by the measurement unit 24. The arrangement 10 comprises external communication interfaces 23 to which each of the measurement units 24 is connected for communicating respectively generated digital data concerning the determined electric parameter to some external entity, such as an external computer or external monitoring system.

In more detail, when the first electrical conductor 11 that passes to each through-hole 14 and thus also through each detection unit 16 generates an electric field, e.g. by a voltage being present on the first electrical conductor 11, this is capacitively sensed by a second electrical conductor 20 of a respective detection unit 16. Each second electrical conductor 20 may thus also be referred to as a capacitive electrode or antenna. One exemplary electric parameter of each second electrical conductor 20 the changes as a function of the electric field of a respective first electrical conductor 11 is a voltage. Accordingly, each respectively associated measurement unit 24 may be configured to determine and in particular quantify a respective voltage present at each second electrical conductor 20. Based thereon, each measurement unit 24 may infer on and/or compute a voltage present at a respectively associated first electrical conductor 11 that causes a respectively measured voltage at the second electrical conductor 20. This voltage present at a respectively associated first electrical conductor 11 may be output by each measurement unit 24, e.g. as a digital signal.

As an optional further feature, the arrangement 10 of Figure 1 includes a shielding member 26 comprising a number of shielding structures 28, only some of which are marked with a respective reference sign. Each shielding structure 28 is arranged in between two of the detection units 16, e.g. when viewed along the second axis B. Accordingly, each shielding structure 28 structurally separates and/or physically shields two respectively adjacent detection units 16 from one another. A main shielding function concerns an electromagnetic shielding. Each shielding structure 28 and the shielding member 26 in general is made of a conductive material, in particular a metallic material.

Each shielding structure 28 is a plate-shaped and has a depth dimension D extending orthogonally to the carrier element 12 and a length dimension L extending along the carrier element 12. The depth dimension D is it least as large as an extension of each of the adjacent detection units 16 along a respective first axis A. The length dimension L is at least as large as a diameter of each of the adjacent detection units 16 and/or through holes 14.

As an exemplary feature, the shielding member 26 comprises at least one and in the shown example two elongated arms 30 extending along the second axis B and enclosing the detection units 16 in between them. The shielding structures 28 extend in between and connect said arms 30. This results in a grid-like structure of the shielding member 26, wherein a detection unit 16 is arranged in each grid. The shielding structure 28 has a lightweight and cost-efficient design that can be easily mounted and in particular surface-mounted to the carrier element 12.

Still further, the first arrangement 10 comprises at least one and in the shown example two external communication interfaces 23 in form of Ethernet ports for communicatively connecting some external entity thereto. Further, the first arrangement 10 comprises two interfaces 21 for a signal transmission to and/or from a below-discussed second arrangement 30.

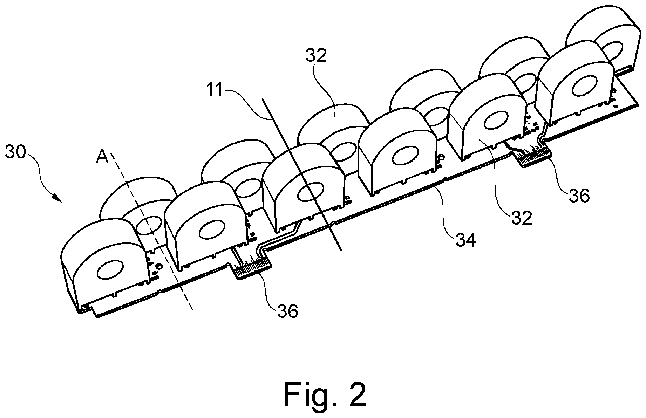

Figure 2 shows a further arrangement 30 that is also referred to as a second arrangement herein. This second arrangement 30 comprises a number of second detection units 32, only some of which are marked with a respective reference sign in Figure 2. The second detection units 32 are mounted to a second carrier element 34 which again is a PCB. Each second detection unit 32 comprises a non-specifically illustrated current transformer through which a respective first electrical conductor 11 can pass. One exemplary first electrical conductor 11 is schematically indicated in Figure 2. In a generally known manner, each current transformer and thus each second detection unit 32 can measure a current at a respective first electrical conductor 11. For example, the current transformer may be configured similarly to the ones disclosed in WO 2021 / 243 304 A1, whereas the so-called antennas disclosed by this reference may be omitted and may in particular replaced by the first detection units 16 of Figure 1 of this disclosure.

Figure 2 further illustrates signal transmitting interfaces 36 at the second carrier element 34 wherein each second detection unit 32 is connected to at least one of said interfaces 36 for a signal transmission.

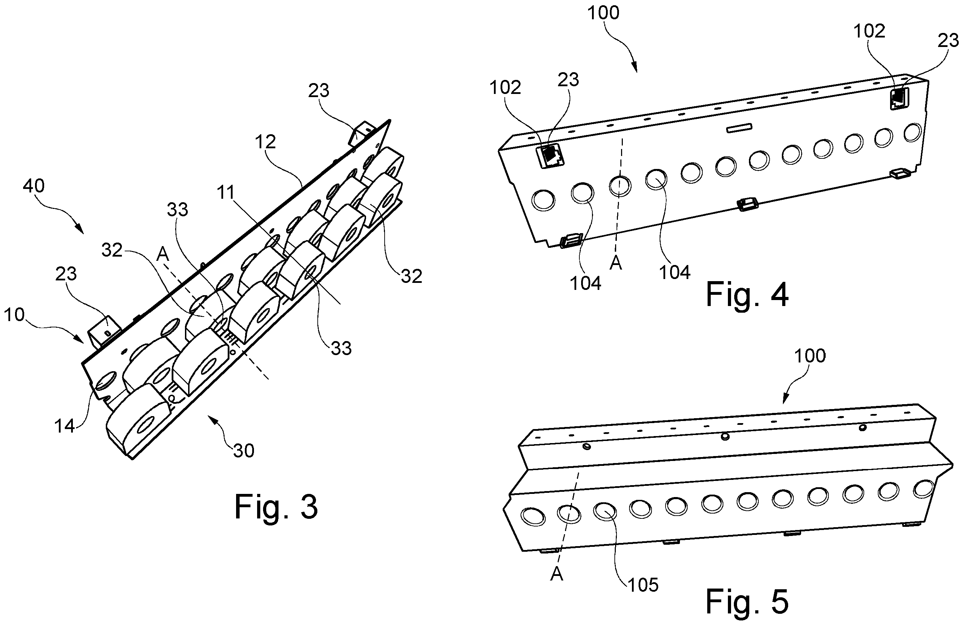

Figure 3 shows an electric measurement system 40 according to an embodiment of this disclosure. The electric measurement system comprises the first arrangement 10 of Figure 1 and the second arrangement 30 of Figure 2. The arrangements 10, 30 are secured to one another, wherein the first carrier element 12 of the first arrangement 10 extends at an angle to the second carrier element 34 of the second arrangement 30. The angle may e.g. be more than 45°, in particular more than 60° and further in particular substantially 90°. The interfaces 36 of the second arrangement 30 are connected to compatible interfaces 21 (see Figure 1) comprised by the first arrangement 10 for enabling a signal transmission between the first and second arrangements 10, 30.

In Figure 3, a rear side of the first arrangement 10 faces the viewer, said rear side facing away from the viewer in Figure 1. Accordingly, in Figure 3 the detection units 16 of the first arrangement 10 face away from and are thus not visible to the viewer. On the other hand, the through holes 14 can be seen. It can also be seen that these through holes 14 are each aligned with one of the second detection units 32. Specifically, a first axis A of each through-hole 14 also extends through a receiving section of each second detection unit 32, said receiving section being formed as a through hole 33. As a result, a first electrical conductor 11 which is schematically illustrated for one pair of through-holes 14, 33 can pass through said through-holes 14, 33 and thus through both detection units 16, 32 of both of the first and second arrangement 10, 30. As a result, both of a current and a voltage applied to and/or present on a first electrical conductor 11 can be accurately measured.

The electric measurement system 40 is marked by a space efficient design. Also, manufacture is simplified because the first and second arrangement 10, 30 may comprise surface mounted detection units 16, 32 and/or can generally be optimized for an automated placement of their respectively comprised components. Still further, measurement accuracy can be improved, e.g. because the first and second detection units 16, 32 can be placed at a distance to one another and/or can be at least somewhat shielded from one another by the first carrier element 12.

Figures 4 and 5 are views of respectively opposite sides of an exemplary housing 100 in which the first and second arrangement 10, 30 according to Figure 3 may be housed. Figure 4 is a view of a side of the housing 100 that is close to and in particular adjacent to the first arrangement 10. It comprises openings 102 for at least one and in the shown example for two external communication interfaces 23 (see Figures 1 & 3). These are provided at the first arrangement 10 in order to connect some external entity thereto, such as an external computer or an external monitoring system. In the shown example, these external communication interfaces 23 are Ethernet ports.

Further, the housing 102 comprises a plurality of openings 104, only some of which are marked with a respective reference sign. These openings 104 are each aligned with a respective first axis A and thus each aligned with through holes 14, 33 of the electric measurement system 40 (see Figure 3).

Figure 5 is a second view of the housing 100 and specifically a view of a side of the housing 100 adjacent to the second arrangement 30. Again, openings 105 are provided that are aligned with the axes A and thus with the through holes 14, 33 of the electric measurement system 40 (see Figure 3). Accordingly, the openings 104, 105 of the housing 100 that are arranged are different sides form channels through which a non-specifically illustrated first electrical conductor 11 of the above-explained kind can pass, so as to be inserted along and through the through-holes 14, 33 of the electrical measurement system 40.

Apart from the above-discussed openings 102, 104, 105 the housing 100 may enclose and thus protect the first and second arrangements 10, 30. The housing 100 may comprise several parts that are not specifically highlighted in Figures 4 and 5 and that may be attached to one another, while enclosing the first and second arrangement 10, 30 in between them.

## Claims

1. An arrangement (10) for detecting at least one electric parameter, the arrangement comprising:
• a carrier element (12) having a plurality of through holes (14) for passing a respective first electrical conductor (11) through each through hole (14) along a respective first axis (A);
• a plurality of detection units (16) each being aligned with one of the through holes (14), wherein each detection unit (16) comprises at least one second electrical conductor (20) which extends at least partially in a circumferential direction around the first axis (A);
• one or more measurement units (24) each being configured to measure at least one electric parameter of one or more of the second electrical conductors (20), the electric parameter varying according to an electrical field generated by one of the first electrical conductors (11).

2. The arrangement (10) according to claim 1,
wherein the carrier element (12) is a printed circuit board.

3. The arrangement (10) according to any of the previous claims,
wherein each detection unit (16) and/or the one or more measurement units (24) are surface mounted to the carrier element (12) and/or are soldered to the carrier element (12).

4. The arrangement (10) according to any of the previous claims,
wherein the second electrical conductor (20) of at least one of the detection units (16) extends with a closed circumference around the first axis (A), in particular wherein the second electrical conductor (20) has a hollow cylindrical shape.

5. The arrangement (10) according to any of the previous claims,
wherein the detection units (16) are capacitive voltage detection units.

6. The arrangement (10) according to any of the previous claims,
wherein at least one of the detection units (16) has a support member (18) extending at least partially in a circumferential direction around the first axis (A), wherein the second electrical conductor (20) is supported by the support member (18).

7. The arrangement (10) according to claim 6,
wherein the support member (18) is electrically non-conductive and/or wherein the support member (18) has a hollow cylindrical shape.

8. The arrangement (10) according to claim 6 or 7,
the support member (18) has a first face facing the first electrical conductor (11) and in particular extending circumferentially around the first electrical conductor (11), and wherein the support member (18) has a second face facing away from the first face, wherein the second electrical conductor (20) is arranged at the second face.

9. The arrangement (10) according to any of the previous claims,
wherein the detection units (16) are aligned along a second axis (B), in particular wherein the second axis (B) extends at an angle to each first axis (A) .

10. The arrangement (10) according to any of the previous claims,
further comprising at least one shielding structure (28) that is arranged in between at least two of the detection units (16) and that is configured to at least partially electromagnetically shield said detection (16) units from one another.

11. The arrangement (10) according to claim 10,
comprising a plurality of shielding structures (28) that are comprised by a common shielding member (26) arranged at the carrier member (12) .

12. The arrangement (10) according any of the previous claims,
wherein at least one of the detection units (16) has one second electrical conductor (20) that is electrically connected to the one or more measurement units (24) and at least one further second electrical conductor (20) that is electrically connected to a ground potential.

13. An electric measurement system,
comprising a first arrangement (10) that is an arrangement according to any of claims 1 to 12; and
a second arrangement (30), the second arrangement (30) comprising a plurality of second detection units (32) each configured to detect an electrical current present in one of the respective first electrical conductors (11);
wherein each second detection unit (32) comprises a receiving section (33) for passing a respective first electrical conductor (11) through, each receiving section (33) being aligned with one of the through holes (14) and/or detection units (16) of the first arrangement (10).

14. The electric measurement system according to claim 13,
wherein the second arrangement (30) comprises a further carrier element (34) at which the second detection units (32) are arranged,
wherein the further carrier element (34) extends at an angle to the carrier element (12) of the first arrangement (10).

15. The electric measurement system according to any of claims 13 to 14,
wherein the first arrangement (10) and the second arrangement (30) are at least partially received in a housing (100) of the electric measurement system (40).

16. Method for manufacturing an electric measurement system (40),
the electric measurement system (40) comprising a first arrangement (10) that is an arrangement according to any of claim 1 to 12; and
a second arrangement (30), the second arrangement (30) comprising a plurality of second detection units (32) each configured to detect an electrical current present in one of the respective first electrical conductors (11);
wherein each second detection unit (32) comprises a receiving section (33) for passing a respective first electrical conductor (11) through, each receiving section (33) being aligned with one of the through holes (14) and/or detection units (16) of the first arrangement (10), and wherein the second arrangement (30) comprises a further carrier element (34) at which the second detection units (32) are arranged;
wherein the method comprises:
• arranging the carrier element (12) of the first arrangement (10) at an angle to the further carrier element (34) of second arrangement (30).
